# EUROPÄISCHE PATENTANMELDUNG

(11) **EP 4 756 547 A1**
(43) Veröffentlichungstag der Anmeldung: **10.06.2026**
(21) Anmeldenummer: 24218173.3
(22) Anmeldetag: 06.12.2024
(51) Int. Cl.: G05B 19/19, G05B 19/408, G05B 19/4099, H01J 37/302

(54) **COMPUTERIMPLEMENTIERTES VERFAHREN, VERFAHREN ZUM ANSTEUERN EINES FÜNF-ACHS-KINEMATIK-SYSTEMS, WERKSTÜCK UND IONENSTRAHLBEARBEITUNGSANLAGE**

(71) Anmelder: Bühler Alzenau GmbH, 63755 Alzenau (DE)
(72) Erfinder: Guertler, Steffen, 04564 Böhlen (DE); Kettmann, Christian, 01900 Grossröhrsdorf (DE); Schindler, Christian, 04668 Grimma (DE)
(74) Vertreter: Prinz & Partner mbB

(57) **Zusammenfassung**

Es wird ein computerimplementiertes Verfahren zur Ausgabe von Ansteuerungsdaten für ein Achssystem einer Ionenstrahlbearbeitungsanlage (10) zum Bearbeiten eines Werkstücks (12) mittels eines lonenstrahls (14) angegeben. Gemäß dem Verfahren gleicht die Recheneinheit (20) Ist-Werkstückdaten des zu bearbeitenden Werkstücks (12) mit Zieldaten ab und erzeugt basierend auf dem Abgleich Bearbeitungsdaten, wobei die Bearbeitungsdaten zumindest einen Bearbeitungswinkel, einen Verfahrweg (22) und eine Verweilzeit eines lonenstrahls (14) umfassen. Die Recheneinheit (20) erzeugt basierend auf den Bearbeitungsdaten Ansteuerungsdaten zum Ansteuern eines Fünf-Achs-Kinematik-Systems (18) der Ionenstrahlbearbeitungsanlage (10), wobei die Ansteuerungsdaten derart ausgebildet sind, dass mittels der Ansteuerungsdaten drei Achsen des Fünf-Achs-Kinematik-Systems (18) im Simultanachsverbund angesteuert werden und die zwei weiteren Achsen des Fünf-Achs-Systems (18) lediglich als Zustellachsen dienen. Des Weiteren werden ein Verfahren zum Ansteuern eines Fünf-Achs-Kinematik-Systems (18) einer Ionenstrahlbearbeitungsanlage (10) zum Bearbeiten eines nicht-planen Werkstücks (12), ein Werkstück und eine Ionenstrahlbearbeitungsanlage (10) angegeben.

## Beschreibung

Die Erfindung betrifft ein computerimplementiertes Verfahren zur Ausgabe von Ansteuerungsdaten für ein Achssystem einer lonenstrahlbearbeitungsanlage. Ferner betrifft die Erfindung ein Verfahren zum Ansteuern eines Fünf-Achs-Kinematik-Systems einer lonenstrahlbearbeitungsanlage zum Bearbeiten eines nicht-planen Werkstücks sowie ein Werkstück mit einer nicht-sphärischen Oberfläche und eine Ionenstrahlbearbeitungsanlage.

Ionenstrahlbearbeitungsanlagen mit einem Fünf-Achs-Kinematik-System ermöglichen die Bearbeitung nicht-planer Werkstücke zur Korrektur von geometrischen Unebenheiten, um so die Oberflächenbeschaffenheit des Werkstücks zu optimieren.

Um optimale Ergebnisse zu erzielen, muss der lonenstrahl bei der Bearbeitung in einem definierten Winkel zur Oberfläche stehen, beispielsweise orthogonal zur Oberfläche. Um dies zu gewährleisten, ist zur Bewegung der lonenquelle das Fünf-Achs-Kinematik-System vorgesehen, wobei alle fünf Achsen im Achs-Verbund simultan angesteuert werden.

Fünfachsige Bewegungen sind jedoch technisch komplex und daher mit einem hohen Steuerungsaufwand verbunden.

Es ist zur Bearbeitung von Werkstücken mit lonenstrahlen auch bekannt, ein dreiachsiges Bearbeitungssystem einzusetzen, das eine Bewegung entlang von drei insbesondere translatorischen Achsen ermöglicht. Ein solches Bearbeitungssystem ist deutlich einfacher anzusteuern als fünfachsige Bearbeitungssysteme. Allerdings ist mit dreiachsigen Bearbeitungssystemen keine Bearbeitung unter einem definierten Winkel möglich, was zu einer ungenauen Bearbeitung führt. In einem gewissen Maße ist es möglich, diese Ungenauigkeit durch eine Korrektur der Bearbeitungsdaten in Form einer Fehlervorhaltung auszugleichen. Allerdings ist dadurch die Geometrie, genauer gesagt eine mögliche Krümmung des zu bearbeitenden Werkstücks eingeschränkt. Zudem kommt es bei einer dreiachsigen Bearbeitung zu unsymmetrischen Verteilungen zumindest einiger Werkstückparameter, beispielsweise der Mikrorauigkeit. Bei hohen Anforderungen an die Genauigkeit sowie bei der Bearbeitung von relativ stark gekrümmten Werkstücken bietet die dreiachsige Bearbeitung somit keine ausreichenden Ergebnisse, sodass es in diesen Fällen bisher keine Alternative zur simultanen fünfachsige Bearbeitung gibt.

Es ist die Aufgabe der Erfindung, eine Werkstückbearbeitung in einer lonenstrahlbearbeitungsanlage zu optimieren, insbesondere die Ansteuerung zu vereinfachen und dennoch optimale Ergebnisse zu erzielen.

Diese Aufgabe wird erfindungsgemäß unter anderem gelöst durch ein computerimplementiertes Verfahren zur Ausgabe von Ansteuerungsdaten für ein Achssystem einer lonenstrahlbearbeitungsanlage zum Bearbeiten eines Werkstücks mittels eines lonenstrahls.

Gemäß dem computerimplementieren Verfahren erhält eine Recheneinheit Ist-Werkstückdaten eines zu bearbeitenden Werkstückes und Zieldaten des zu bearbeitenden Werkstücks. Die Recheneinheit gleicht die Ist-Werkstückdaten des zu bearbeitenden Werkstücks mit den Zieldaten ab. Basierend auf dem Abgleich erzeugt die Recheneinheit Bearbeitungsdaten, die zumindest einen Bearbeitungswinkel, einen Verfahrweg und eine Verweilzeit eines lonenstrahls umfassen. Basierend auf den Bearbeitungsdaten erzeugt die Recheneinheit Ansteuerungsdaten zum Ansteuern eines Fünf-Achs-Kinematik-Systems der lonenstrahlbearbeitungsanlage. Die Ansteuerungsdaten sind derart ausgebildet, dass mittels der Ansteuerungsdaten drei Achsen des Fünf-Achs-Kinematik-Systems im Simultanachsverbund angesteuert werden und die zwei weiteren Achsen des Fünf-Achs-Kinematik-Systems lediglich als Zustellachsen dienen.

Indem lediglich drei Achsen des Fünf-Achs-Kinematik-Systems im Simultanachsverbund angesteuert werden, ist die Komplexität der Ansteuerungsdaten sowie der Datenverarbeitung reduziert. Gleichzeitig ist eine durchgehende Bearbeitung des Werkstücks unter einem definierten Bearbeitungswinkel möglich, was in optimierten Bearbeitungsergebnissen resultiert.

Die Bearbeitungsdaten beinhalten beispielsweise eine Verweilzeitkarte ("dwell time map"), Beschleunigungswerte und einen 3D-Weg. Durch die Bearbeitung erfolgt insbesondere eine Änderung der Oberflächenbeschaffenheit, beispielsweise der Mikrorauigkeit, eine Geometrieänderung wie eine Dickenänderung, eine Formänderung und/oder bei Vorhandensein einer Beschichtung eine Änderung der Dicke bzw. Beschaffenheit der Beschichtung.

Ziel der Bearbeitung ist es, eine vorgegebene definierte Geometrie des Werkstücks sowie eine einheitliche Oberflächenbeschaffenheit zu erhalten. Beispielsweise ist die Zielgeometrie eine parabolische Geometrie.

Die Ansteuerungsdaten beinhalten beispielsweise die Ansteuerung von zwei linearen Achsen und einer Schwenkachse.

Mit einem Fünf-Achs-Kinematik-System ist ein System gemeint, das mindestens fünf Achsen hat, das heißt, das System kann auch ein Sechs-Achs-Kinematik-System oder ein Sieben-Achs-Kinematik-System sein.

Basierend auf den Bearbeitungsdaten kann die Auswahl der zwei Zustellachsen erfolgen. Die Zustellachsen bleiben während der Bearbeitung des Werkstücks gleich, das heißt es erfolgt während des Bearbeitungsprozesses keine Änderung der Zustellachsen. Somit bleiben auch die drei im Simultanachsverbund angesteuerten Achsen während eines Bearbeitungsprozesses gleich.

Gemäß einem Aspekt umfassen die Ist-Werkstückdaten mindestens einen der folgenden Parameter: Werkstückgeometrie, Werkstückmaterial, Abtragsrate des Materials, von dem Werkstückmaterial und/oder der Werkstückgeometrie abhängige Parameter, Schwingverhalten, das Vorhandensein einer Beschichtung, eine Dicke einer Beschichtung, ein Material der Beschichtung und eine Mikrorauigkeit. Diese Daten ermöglichen eine hinreichend genaue Beschreibung eines Ist-Zustands des zu bearbeitenden Werkstücks. Je mehr Parameter die Ist-Werkstückdaten umfassen, desto einfacher lassen sich die Bearbeitungsdaten ermitteln.

Die Abtragsrate des Materials wird beispielsweise mittels einer Testbearbeitung des zu bearbeitenden Materials ermittelt. Dabei wird mit dem lonenstrahl eine Standätzung und/oder eine Grabenätzung an einem entsprechenden Testwerkstück vorgenommen und die dabei entstehende Vertiefung bzw. der Graben werden vermessen, woraus die Abtragsrate bestimmt wird. Das Testwerkstück entspricht dem zu bearbeitenden Werkstück zumindest hinsichtlich des Materials.

Bei den vom Werkstückmaterial und/oder der Werkstückgeometrie abhängigen Parametern handelt es sich beispielsweise um eine Reflektivität oder ein Streuverhalten.

Beim Schwingverhalten handelt es sich beispielsweise um eine Eigenschaft einer Subkomponente eines mikroelektromechanischen Systems (MEMS). Insbesondere kann eine solche Subkomponente, genauer gesagt ein mikromechanisches Bauelement, mit einer bestimmten Frequenz schwingen. Diese Frequenz kann durch einen mittels eines lonenstrahls bewirkten Materialabtrag bei Bedarf korrigiert werden.

Bei einer Subkomponente handelt es sich zum Beispiel um ein elektronisches Bauelement wobei mittels des lonenstrahls Material von dem Bauelement abgetragen wird.

Bei einem mikroelektromechanischen System handelt es sich beispielsweise um einen Beschleunigungssensor, ein Mikrofon, einen Filter, beispielsweise einen Frequenzfilter oder ähnliches.

Eine Schwingfrequenz einer Komponente wird auch durch eine auf das Werkstück aufgebrachte Beschichtung beeinflusst. Die Beschichtung stellt insbesondere eine Opferschicht dar, wobei durch Abtragen der Beschichtung mittels eines lonenstrahls die Masse der Beschichtung reduziert wird, wodurch die Schwingfrequenz einer Komponente korrigiert werden kann.

Die Ist-Werkstückdaten können entweder mittels einer Analyse des zu bearbeitenden Werkstücks erhalten werden oder vorgegeben sein. Insbesondere können solche Ist-Werkstückdaten vorgegeben werden, welche durch eine Grundform oder ein Grundmaterial des Werkstücks vorgegeben sind, wohingegen solche Ist-Werkstückdaten, die individuell für ein Werkstück sind, beispielsweise lokale Geometrieabweichungen, in der Regel analysiert werden.

Die Zieldaten können mindestens einen der folgenden Parameter umfassen: Mikrorauigkeit, Werkstückgeometrie, Schwingverhalten, eine Dicke einer Beschichtung, ein Material der Beschichtung und eine Mikrorauigkeit. Die Zieldaten können alle Parameter umfassen, welche sich durch die Bearbeitung mit einem lonenstrahl anpassen lassen. Mittels der Zieldaten lässt sich folglich ein gewünschter Zustand des Werkstücks nach der Bearbeitung beschreiben.

Gemäß einer Ausführungsform erhält die Recheneinheit Abtragsprofildaten des lonenstrahls, wobei die Abtragsprofildaten berücksichtigt werden, wenn die Bearbeitungsdaten von der Recheneinheit erzeugt werden. Dies ermöglicht eine besonders genaue Bearbeitung des Werkstücks. Die Abtragsprofildaten umfassen Daten zum Abtragsprofil des lonenstrahls. Diese Daten können in-situ in der lonenstrahlbearbeitungsanlage erfasst werden, deren Recheneinheit das computerimplementierte Verfahren ausführt, oder vorgegeben sein, bspw. aufgrund einer Messung bei einer Referenz-Ionenstrahlbearbeitungsanlage, also einer baugleichen lonenstrahlbearbeitungsanlage.

Die Aufgabe wird des Weiteren erfindungsgemäß gelöst durch ein Verfahren zum Ansteuern eines Fünf-Achs-Kinematik-Systems einer lonenstrahlbearbeitungsanlage zum Bearbeiten eines nicht-planen Werkstücks, insbesondere eines nicht-sphärischen bzw. parabolischen Werkstücks, wobei die lonenstrahlbearbeitungsanlage ein Fünf-Achs-Kinematik-System und mindestens eine durch das Fünf-Achs-Kinematik-System bewegbare lonenstrahlquelle sowie eine Recheneinheit zum Ansteuern des Fünf-Achs-Kinematik-Systems umfasst.

In einem ersten Verfahrensschritt erhält die Recheneinheit Ist-Werkstückdaten eines zu bearbeitenden Werkstücks. Die Ist-Werkstückdaten des Werkstücks werden mit Zieldaten des Werkstücks verglichen und basierend auf einer Abweichung der Ist-Werkstückdaten von den Zieldaten wird ein Bearbeitungsprofil durch die Recheneinheit erstellt. Das Bearbeitungsprofil umfasst einen Verfahrweg, eine Verweilzeit und einen Anstellwinkel der lonenstrahlquelle relativ zu der Oberfläche des Werkstücks. Die Recheneinheit steuert entsprechend dem Bearbeitungsprofil drei Achsen des Fünf-Achs-Kinematik-Systems simultan an, um die lonenstrahlquelle mit einer dem Bearbeitungsprofil entsprechenden Verweilzeit und einem dem Bearbeitungsprofil entsprechenden Anstellwinkel entlang des Verfahrwegs zu verfahren. Die übrigen beiden Achsen des Fünf-Achs-Kinematik-Systems steuert die Recheneinheit lediglich zum Zustellen der lonenstrahlquelle an den Verfahrweg an.

Erfindungsgemäß ist der Rechenaufwand zum Ansteuern der Fünf-Achs-Kinematik reduziert, wenn lediglich drei Achsen simultan angesteuert werden. Zudem ist durch das erfindungsgemäße Verfahren die Bearbeitungsgenauigkeit gegenüber dreiachsigen Bearbeitungssystemen verbessert.

Gemäß einer Ausführungsform wird das Werkstück analysiert, um Ist-Werkstückdaten des Werkstücks zu erfassen. Eine möglichst genaue Kenntnis der Ist-Werkstückdaten ermöglicht eine besonders zielgenaue Bearbeitung des Werkstücks. Zudem ist es durch eine entsprechende Analyse möglich, Unterschiede in den Ist-Werkstückdaten der Werkstücke einer Charge festzustellen.

Alternativ ist es möglich, die Ist-Werkstückdaten oder zumindest einen Teil der Ist-Werkstückdaten vorzugeben.

Gemäß einem Aspekt steuert die Recheneinheit zwei zueinander orthogonale lineare Achsen und eine Schwenkachse simultan an. Durch eine derartige Ansteuerung ist es möglich, eine lonenstrahlquelle entlang einer geradlinigen Bewegungsbahn zu verfahren und dabei einen Bearbeitungswinkel flexibel einzustellen.

Mit dem Bearbeitungswinkel ist der Winkel eines lonenstrahls relativ zu einer Werkstückoberfläche gemeint.

Alternativ ist eine Ansteuerung gemäß einer Parallelkinematik denkbar. Dabei werden beispielsweise zwei parallele lineare Achsen und eine Schwenkachse oder drei parallele lineare Achsen simultan angesteuert.

Beispielsweise wird für unterschiedliche auf dem Werkstück liegende lokale Bereiche jeweils ein eigenes Bearbeitungsprofil erstellt. Dies ermöglicht eine besonders zielgenaue Bearbeitung der Werkstückoberfläche.

Bei den lokalen Bereichen handelt es sich beispielsweise um Kreisbereiche. Die Bereiche können aber auch andere Formen als Kreise haben.

Es ist auch denkbar, dass nicht die gesamte Oberfläche des Werkstücks bearbeitet wird, sondern nur einzelne Teilbereiche. Letztendlich hängt dies vom Abgleich ab, also dem Ergebnis, wenn die Ist-Werkstückdaten mit den Zieldaten abgeglichen worden sind.

Vor dem Bearbeiten des Werkstücks kann ein Abtragsprofil des lonenstrahls erfasst werden und das Bearbeitungsprofil kann unter Berücksichtigung des Abtragsprofils erstellt werden. Durch die Erfassung des Abtragsprofils des lonenstrahls können Variationen in der Materialabtragung, die beispielsweise durch die Strahlintensität oder Strahlungsform bedingt sind, berücksichtigt werden. Das Bearbeitungsprofil kann entsprechend angepasst werden, um eine gleichmäßige und präzise Oberflächenbearbeitung zu gewährleisten.

Das Abtragsprofil des lonenstrahls beinhaltet beispielsweise einen lonenstrom, eine Ionenart sowie das Material des zu bearbeitenden Werkstücks. Anders ausgedrückt bildet das Abtragsprofil den mit dem lonenstrahl in einem Durchgang erreichten Materialabtrag ab. Dabei ist das Abtragsprofil auch von einer Umgebung abhängig.

Im Laufe der Lebensdauer ändert sich das Abtragsprofil, sodass zu gegebener Zeit das Abtragsprofil neu erfasst werden sollte, insbesondere in regelmäßigen Zeitabständen.

Das Abtragsprofil kann in der lonenstrahlbearbeitungsanlage erfasst werden, beispielsweise durch eine Testbearbeitung eines Werkstücks. Hierdurch lassen sich die Abtragsprofildaten erfassen.

Alternativ ist es denkbar, die Abtragsprofildaten einzulesen. Die eingelesenen Abtragsprofildaten können von einer Referenz-lonenstrahlbearbeitungsanlage erhalten worden sein.

Das Abtragsprofil entspricht beispielsweise näherungsweise einem Gaußprofil, insbesondere einer Überlagerung mehrerer Gaußprofile.

Gemäß einem Aspekt bleibt der Anstellwinkel des lonenstrahls relativ zur Oberfläche des Werkstücks während eines Bearbeitungsvorgangs konstant. In der Regel ist der Bearbeitungswinkel orthogonal zur Werkstückoberfläche. Grundsätzlich kann jedoch jeder beliebige Bearbeitungswinkel eingestellt werden, sofern dies aufgrund der Zielgeometrie des Werkstücks gewünscht ist, was in den Zieldaten entsprechend enthalten ist. Bei einem konstanten Bearbeitungswinkel relativ zur Oberfläche ist es nicht notwendig, die Winkelabhängigkeit des Abtragsprofils zu berücksichtigen, was ebenfalls zu einer reduzierten Komplexität der Bearbeitung beiträgt.

Durch einen konstanten Bearbeitungswinkel werden unsymmetrische Effekte aufgrund wechselnder Winkel zwischen lonenquelle und Werkstückoberfläche vermieden. Auch andere Effekte wie Rücksputtern oder Kontaminationen werden durch einen konstanten Bearbeitungswinkel weitestgehend vermieden.

Es ist jedoch grundsätzlich möglich, durch eine Änderung des Bearbeitungswinkels gezielt eine definierte Unsymmetrie zu erzeugen.

Die Recheneinheit kann eingerichtet sein, die lonenstrahlquelle derart anzusteuern, dass der lonenstrahl während der Bearbeitung pulsiert. Auf diese Weise kann ein Energieeintrag des lonenstrahls kontrolliert werden, wodurch die Abtragsrate bzw. der Materialabtrag entsprechend gesteuert werden kann. Grundsätzlich lassen sich unerwünschte thermische Effekte durch die pulsierende Ansteuerung der lonenstrahlquelle vermeiden.

Die Intensität des lonenstrahls kann während eines Bearbeitungsvorgangs konstant bleiben, insbesondere in einem zeitlichen Mittel. Bei einem gepulsten Betrieb bleibt die Intensität im zeitlichen Mittel konstant. Eine konstante Intensität sorgt für einen gleichmäßigen Materialabtrag, wodurch präzise Bearbeitungsergebnisse erzielt werden können. Zudem lassen sich mit einer konstanten Intensität reproduzierbare Bearbeitungsergebnisse erzielen. Das Risiko von Bearbeitungsfehlern ist somit reduziert. Insbesondere bei einem gepulsten Betrieb mit einer konstanten Intensität lassen sich die unerwünschte thermische Effekte vermeiden.

Gemäß einem Aspekt ist die lonenstrahlquelle fokussiert, insbesondere wobei der Querschnitt des lonenstrahls während eines Bearbeitungsvorgangs verändert wird. Dies kann zwischen verschiedenen Abschnitten des Verfahrwegs und/oder innerhalb eines Abschnitts erfolgen. Ein fokussierter lonenstrahl ermöglicht die gezielte Bearbeitung spezifischer Werkstückbereiche mit hoher Präzision. Durch eine Veränderung des Querschnitts während der Bearbeitung können Bereiche, in denen ein erhöhter Materialabtrag, insbesondere in der Fläche, erforderlich ist, effizient bearbeitet werden, beispielsweise Bereiche, in denen eine Erhebung auf dem Werkstück vorhanden ist, die entfernt werden soll.

Der Verfahrweg ist beispielsweise mäanderförmig. Das bedeutet, der Verfahrweg setzt sich zusammen aus mehreren parallelen Bahnen, die miteinander durch Verbindungsabschnitte verbunden sind. Die parallelen Bahnen, auch als Abschnitte bezeichnet, können geradlinig auf einem Kleinkreis entlang einer kugelförmigen Oberfläche verlaufen. Die Kleinkreise entsprechen insbesondere Breitenkreise bzw. Breitengrade auf einer Kugeloberfläche. Anders ausgedrückt versteht man unter Kleinkreisen jene Kreise auf einer Kugeloberfläche, deren Ebenen nicht den Kugelmittelpunkt enthalten. Ein derartiger Verfahrweg lässt sich durch drei simultan angesteuerte Achsen in Kombination mit zwei Zustellachsen einfach realisieren. Insbesondere dienen die Zustellachsen dazu, die lonenstrahlquelle entlang des Verbindungsabschnittes zu verfahren, während mittels der simultan angesteuerten Achsen der Verfahrweg entlang der parallelen Bahnen realisiert wird. Während des Verfahrens entlang der parallelen Bahnen erfolgt auch die Bearbeitung des Werkstücks.

Die Aufgabe wird des Weiteren erfindungsgemäß gelöst durch ein Werkstück mit einer nicht-sphärischen Oberfläche, das mittels eines erfindungsgemäßen Verfahrens bearbeitet wurde, wobei das Werkstück über die bearbeitete Oberfläche hinweg eine einheitliche Mikrorauigkeit aufweist. Eine derartige einheitliche Mikrorauigkeit lässt sich insbesondere realisieren, wenn der Bearbeitungswinkel während des gesamten Bearbeitungsprozesses konstant ist, wie es durch das erfindungsgemäße Verfahren möglich ist.

Die Aufgabe wird zudem gelöst durch eine lonenstrahlbearbeitungsanlage zum Bearbeiten eines Werkstücks mittels eines lonenstrahls, wobei die lonenstrahlbearbeitungsanlage ein Fünf-Achs-Kinematik-System und mindestens eine durch das Fünf-Achs-Kinematik-System bewegbare lonenstrahlquelle sowie eine Recheneinheit zum Ansteuern des Fünf-Achs-Kinematik-Systems umfasst, und wobei die Recheneinheit eingerichtet ist, das erfindungsgemäße computerimplementierte Verfahren auszuführen, um das Fünf-Achs-Kinematik-System mittels der erzeugten Ansteuerungsdaten anzusteuern. Die lonenstrahlbearbeitungsanlage ist grundsätzlich eingerichtet, das zuvor beschriebene Verfahren auszuführen. Wie bereits in Zusammenhang mit dem Verfahren beschrieben, ist in einer derartigen lonenstrahlbearbeitungsanlage die Komplexität der Ansteuerdaten sowie der Datenverarbeitung reduziert. Dadurch lässt sich auch die mechanische Komplexität der Anlage reduzieren, wodurch die Kosten gesenkt werden können. Zudem ist auch die Bearbeitung von relativ stark gekrümmten Werkstücken mit hoher Präzision möglich.

Weitere Vorteile und Merkmale der Erfindung ergeben sich aus der nachfolgenden Beschreibung und aus den beiliegenden Zeichnungen, auf die Bezug genommen wird. In den Zeichnungen zeigen:
- Figur 1 eine erfindungsgemäße lonenstrahlbearbeitungsanlage zur Herstellung eines erfindungsgemäßen Werkstücks,
- Figur 2 ein Fünf-Achs-Kinematik-System,
- Figur 3 ein erfindungsgemäßes Werkstück mit einem auf diesem veranschaulichten Verfahrweg,
- Figur 4 eine Oberfläche eines Werkstücks vor der Bearbeitung in einer lonenstrahlbearbeitungsanlage gemäß Figur 1,
- Figur 5, eine Verweilzeitkarte zur Bearbeitung des Werkstücks gemäß Figur 4,
- Figur 6 eine Oberfläche des Werkstücks aus Figur 4 nach der Bearbeitung in einer lonenstrahlbearbeitungsanlage gemäß Figur 1 entsprechend der in Figur 5 gezeigten Verweilzeitkarte,
- Figur 7 ein Abtragsprofil eines lonenstrahls,
- Figur 8 ein Ablaufschema zur Veranschaulichung eines erfindungsgemäßen computerimplementierten Verfahrens,
- Figur 9 eine Parallelkinematik für eine lonenstrahlbearbeitungsanlage, und
- Figur 10 eine weitere Parallelkinematik für eine lonenstrahlbearbeitungsanlage.

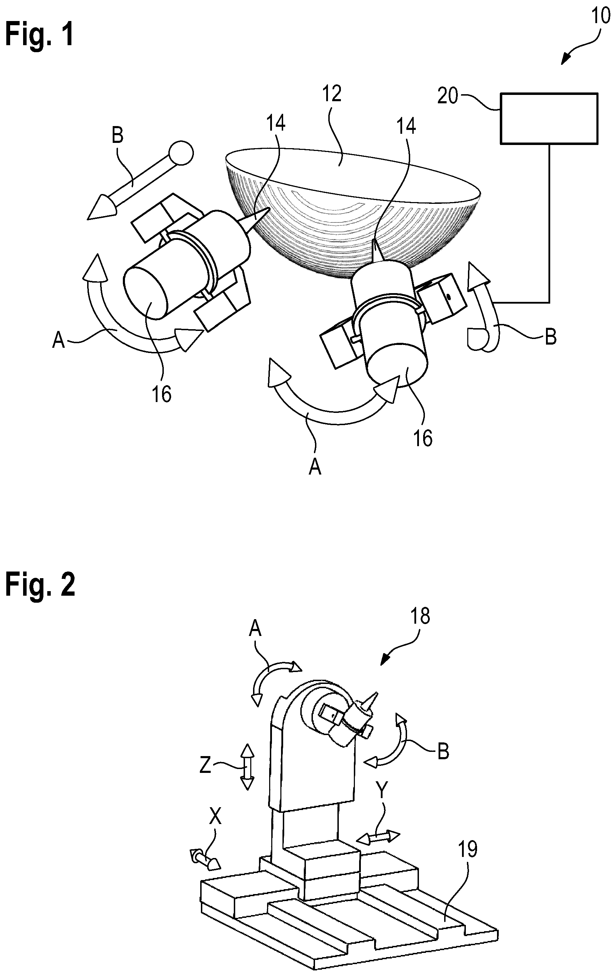

Figur 1 zeigt teilweise schematisch eine lonenstrahlbearbeitungsanlage 10 zum Bearbeiten eines Werkstücks 12 mittels eines lonenstrahls 14. Die lonenstrahlbearbeitungsanlage 10 eignet sich insbesondere zur Bearbeitung eines nicht-planen Werkstücks, insbesondere eines nicht-sphärischen bzw. parabolischen Werkstücks.

Die lonenstrahlbearbeitungsanlage 10 umfasst zumindest eine lonenstrahlquelle 16, die mittels eines Fünf-Achs-Kinematik-Systems 18, welches in Figur 2 veranschaulicht ist, in der lonenstrahlbearbeitungsanlage 10 bewegt werden kann. In Figur 1 ist die lonenstrahlquelle 16 in zwei unterschiedlichen Positionen gezeigt.

Der in Figur 1 veranschaulichte Aufbau ist insbesondere im Vakuum angeordnet. In anderen Worten findet eine Bearbeitung mittels des lonenstrahls 14 im Vakuum statt.

Das Fünf-Achs-Kinematik-System 18 hat im Ausführungsbeispiel drei lineare Achsen, insbesondere eine x-Achse, eine y-Achse und eine z-Achse sowie zwei Schwenkachsen, insbesondere die Schwenkachsen A und B. In Figur 1 sind aufgrund der besseren Anschaulichkeit lediglich die Schwenkachsen A und B veranschaulicht.

Wie in Figur 2 zu sehen ist, ist eine erste lineare Achse, im Ausführungsbeispiel die x-Achse, auf einer Grundplatte 19 angebracht. Zum Verfahren entlang der x-Achse können ein bis vier parallele lineare Motoren vorhanden sein. Senkrecht zur x-Achse verläuft eine zweite lineare Achse, im Ausführungsbeispiel die y-Achse. Zum Verfahren entlang der y-Achse können ein bis zwei parallele lineare Motoren vorhanden sein. Senkrecht zur x-Achse und zur y-Achse verläuft eine dritte lineare Achse, im Ausführungsbeispiel die z-Achse. Im Ausführungsbeispiel befindet sich an der dritten linearen Achse, also der z-Achse, ein schwenkbewegliches Element, wodurch die Schwenkachse A, welche die vierte Achse bildet, realisiert ist. Die Schwenkachse A verläuft parallel zur ersten linearen Achse, also der x-Achse. Zum Verschwenken um die A-Achse können ein bis zwei rotatorische Motoren vorhanden sein. An der A-Achse befindet sich die Schwenkachse B, welche die fünfte Achse bildet. Die Schwenkachse B verläuft senkrecht zur Schwenkachse A und senkrecht zur ersten linearen Achse, also der x-Achse. Zum Verschwenken um die B-Achse können ein bis zwei rotatorische Motoren angeordnet sein.

Die lonenstrahlquelle 16 ist mit der Schwenkachse B fest gekoppelt, wobei die Richtung des lonenstrahls einen festen Winkel zur A-Achse und zur B-Achse hat. Im Ausführungsbeispiel sind diese Winkel senkrecht.

Des Weiteren umfasst die lonenstrahlbearbeitungsanlage 10 eine Recheneinheit 20, auf der eine Software hinterlegt ist, über die die Fünf-Achs-Kinematik-System 18 angesteuert wird.

Die Recheneinheit 20 ist also eingerichtet, das Fünf-Achs-Kinematik-System 18 anzusteuern, was nachfolgend noch im Detail erläutert wird.

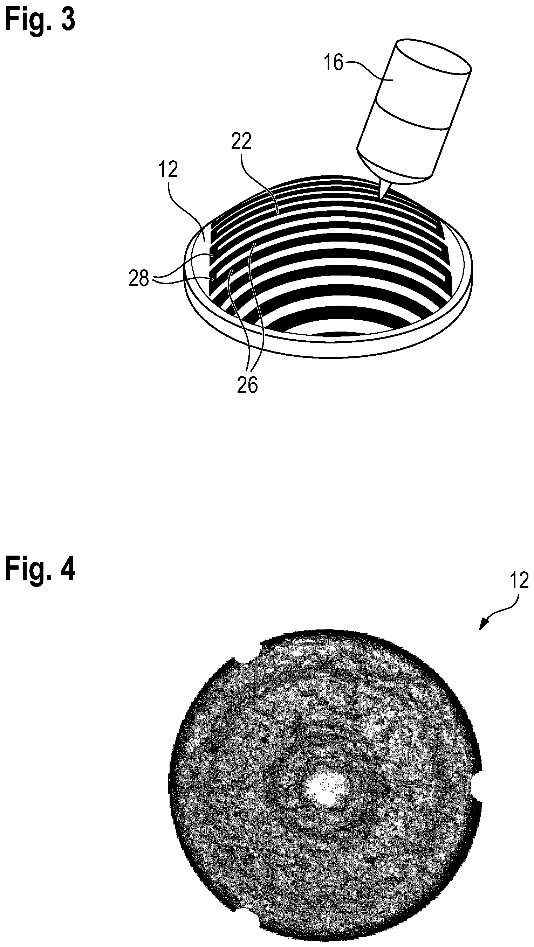

Konkret ist die Recheneinheit 20 eingerichtet, die lonenstrahlquelle 16 entlang eines Verfahrwegs 22 zu verfahren. Ein derartiger Verfahrweg 22 entlang des Werkstücks 12 ist in Figur 3 beispielhaft veranschaulicht. Im gezeigten Ausführungsbeispiel ist der Verfahrweg 22 mäanderförmig.

Im Folgenden wird anhand der Figuren 1 bis 7 zunächst ein Verfahren zum Ansteuern des Fünf-Achs-Kinematik-Systems 18 der lonenstrahlbearbeitungsanlage 10 zum Bearbeiten des nicht-planen Werkstücks 12 beschrieben.

Zu Beginn des Verfahrens erhält die Recheneinheit 20 Ist-Werkstückdaten des zu bearbeitenden Werkstücks 12.

Zu den Ist-Werkstückdaten zählen eine Werkstückgeometrie, beispielsweise eine Grundform des Werkstücks 12 und/oder eine Oberflächengeometrie, ein Werkstückmaterial, eine Abtragsrate des Materials, weitere von dem Werkstückmaterial und/oder der Werkstückgeometrie abhängige Parameter wie eine Reflektivität oder ein Streuverhalten der Werkstückoberfläche, ein Schwingverhalten des Werkstücks, das Vorhandensein einer Beschichtung sowie die Dicke einer Beschichtung.

Ein Werkstück 12 in einem Zustand vor einer Bearbeitung ist in Figur 4 beispielhaft gezeigt. In Figur 4 ist zu sehen, dass das Werkstück 12 vor der Bearbeitung eine unregelmäßige, raue Oberfläche hat. Konkret stellen die dunklen Bereiche tieferliegende Bereiche des Werkstücks 12 dar und die hellen Bereiche stellen höherliegende Bereiche des Werkstücks 12 dar.

Zum Erfassen der Ist-Werkstückdaten kann das Werkstück 12 analysiert werden, beispielsweise optisch. Alternativ ist denkbar, dass zumindest Ist-Werkstückdaten vorgegeben sind, wie zum Beispiel die Grundform des Werkstücks 12, das Vorhandensein einer Beschichtung und/oder das Werkstückmaterial.

Ziel ist es, durch die Bearbeitung des Werkstücks 12 eine definierte Geometrie des Werkstücks 12 sowie eine einheitliche Mikrorauigkeit der Werkstückoberfläche zu erreichen.

Zu diesem Zweck werden Zieldaten des zu bearbeitenden Werkstücks 12 definiert.

Bei den Zieldaten handelt es sich zum Beispiel um eine Mikrorauigkeit, eine Werkstückgeometrie, ein Schwingverhalten des Werkstücks 12 und/oder die Dicke einer Beschichtung. Ein Zielwert der Mikrorauigkeit liegt zum Beispiel im Bereich eines RMS-Wertes von 0,1 nm bis 10 Mikrometer

Die Zieldaten werden der Recheneinheit 20 zur Verfügung gestellt.

In der Recheneinheit 20 werden die Ist-Werkstückdaten des Werkstücks 12 mit Zieldaten des Werkstücks 12 verglichen.

Basierend auf einer Abweichung der Ist-Werkstückdaten von den Zieldaten wird durch die Recheneinheit 20 ein Bearbeitungsprofil für das Werkstück 12 erstellt. Das Bearbeitungsprofil umfasst einen Verfahrweg 22, beispielsweise den in Figur 3 veranschaulichten Verfahrweg, eine Verweilzeit und einen Anstellwinkel der lonenstrahlquelle 16 relativ zu der Oberfläche des Werkstücks 12.

Durch den entsprechenden Verfahrweg 22 wird sichergestellt, dass alle zu bearbeitenden Bereiche auf der Werkstückoberfläche angefahren werden.

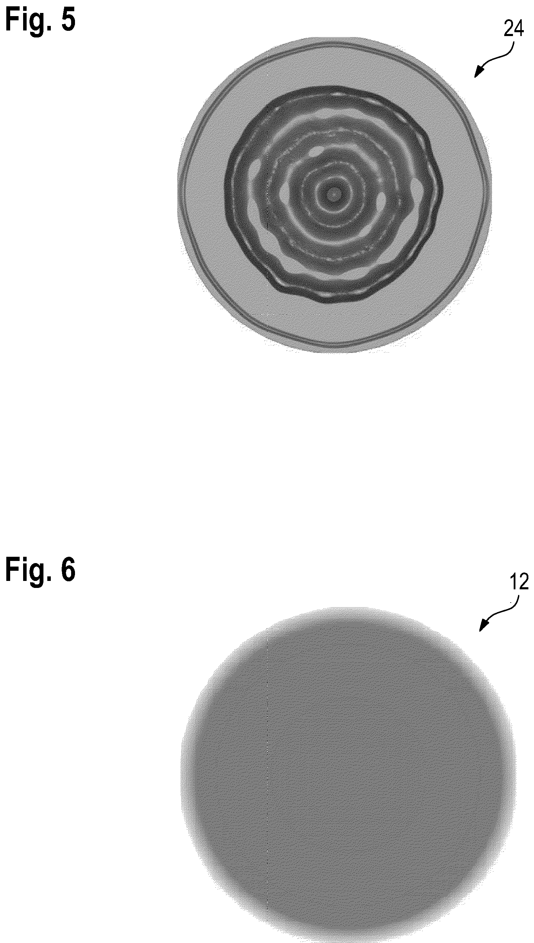

Unter anderem über die Verweilzeit wird definiert, wie viel Material an einer bestimmten Stelle abgetragen werden soll. Je höher der gewünschte Materialabtrag ist, umso länger kann die Verweilzeit sein, insbesondere bei ansonsten gleichbleibender Intensität des von der lonenstrahlquelle 16 erzeugten lonenstrahls 14. Da der gewünschte Materialabtrag in der Regel über die Werkstückoberfläche betrachtet variiert, kann auch die Verweilzeit variieren. Dies lässt sich in einer sogenannten Verweilzeitkarte 24 darstellen, wie sie in Figur 5 veranschaulicht ist. Je dunkler ein Bereich in der Verweilzeitkarte 24 dargestellt ist, umso länger ist die Verweilzeit im entsprechenden Bereich.

Bei der Bearbeitung des Werkstücks 12 findet in der Regel ein Materialabtrag im Bereich von bis zu 10 µm statt, insbesondere ein Materialabtrag von bis zu 1 µm.

Sobald das Bearbeitungsprofil erstellt ist, steuert die Recheneinheit 20 entsprechend des Bearbeitungsprofils drei Achsen des Fünf-Achs-Kinematik-Systems 18 simultan an, um die lonenstrahlquelle 16 mit einer dem Bearbeitungsprofil entsprechenden Verweilzeit und einem dem Bearbeitungsprofil entsprechenden Anstellwinkel entlang des Verfahrwegs 22 zu verfahren und Material durch den lonenstrahl 14 abzutragen.

Der Anstellwinkel des lonenstrahls 14 relativ zur Oberfläche des Werkstücks 12 bleibt während eines Bearbeitungsvorgangs konstant.

Bei den drei im Simultanverbund angesteuerten Achsen handelt es sich im Ausführungsbeispiel um zwei zueinander orthogonale lineare Achsen und eine Schwenkachse, insbesondere die y-Achse, die z-Achse und die A-Achse. Die Schwenkachse ist im Ausführungsbeispiel orthogonal zur y- und z-Achse.

Die übrigen beiden Achsen des Fünf-Achs-Kinematik-Systems 18, im Ausführungsbeispiel die lineare x-Achse und die Schwenkachse B, werden von der Recheneinheit 20 lediglich zum Zustellen der lonenstrahlquelle 16 an den Verfahrweg 22 ansteuert. Während des Zustellens über die Zustellachsen findet aber kein Materialabtrag durch den lonenstrahl 14 statt.

Insofern unterscheiden sich die Zustellachsen von den im Simultanverbund angesteuerten Achsen unter anderem dahingehend, dass während einer Bewegung entlang zumindest einer der Zustellachsen kein lonenstrahl 14 vorliegt, da lediglich ein Zustellen erfolgt.

Betrachtet man den in Figur 3 dargestellten Verfahrweg 22, ist sichtbar, dass der mäanderförmige Verfahrweg 22 eine Vielzahl von parallelen Bahnen 26 und diese verbindende Verbindungsabschnitte 28 hat. Die Verbindungsabschnitte 28 werden auch als Wendestellen bezeichnet.

Die parallelen Bahnen 26 verlaufen im veranschaulichten Ausführungsbeispiel auf Kleinkreisen einer Kugeloberfläche. Während die lonenstrahlquelle 16 entlang der Bahnen 26 bewegt wird, findet die Bearbeitung des Werkstücks 12 statt. Beim Verfahren entlang dieser Bahnen 26 steuert die Recheneinheit 20 die drei genannten Achsen des Fünf-Achs-Kinematik-Systems 18 simultan an. Zudem wird die lonenstrahlquelle 16 von der Recheneinheit 20 angesteuert, damit der lonenstrahl 14 erzeugt wird, wie nachfolgend noch detaillierter erläutert wird.

Durch das Verfahren entlang der Verbindungsabschnitte 28 wird die lonenstrahlquelle 16 von jeweils von einer Bahn 26 auf die nächste Bahn 26 bewegt. Beim Verfahren entlang der Verbindungsabschnitte 28 steuert die Recheneinheit 20 die beiden Zustellachsen an. Beim Verfahren entlang der Verbindungsabschnitte 28 findet keine Bearbeitung statt, wie zuvor schon erläutert wurde.

Es ist auch denkbar, dass die Verbindungsabschnitte 28 außerhalb des Werkstücks 12 liegen, wie es in Figur 3 für einige Bahnen veranschaulicht ist. In diesem Fall muss der lonenstrahl 14 beim Verfahren entlang der Verbindungsabschnitte nicht abgeschaltet werden.

Ob ein Verbindungsabschnitt 28 auf einem Werkstück 12 oder außerhalb des Werkstücks 12 liegt, hängt von der Art des Werkstücks 12 und der Position des zu bearbeitenden Bereichs statt, insbesondere davon, ob eine Oberfläche des Werkstücks 12 vollständig bearbeitet werden soll oder lediglich Teilbereiche davon.

Figur 6 zeigt das Werkstück 12 nach der Bearbeitung. Das in Figur 6 dargestellte bearbeitete Werkstück 12 hat eine einheitliche Oberfläche, insbesondere eine über die bearbeitete Oberfläche hinweg einheitliche Mikrorauigkeit.

Es muss jedoch, je nach Anwendungsfall, nicht zwangsweise die gesamte Oberfläche des Werkstücks 12 bearbeitet werden, sondern es ist auch denkbar, dass nur lokale Bereiche des Werkstücks 12, genauer gesagt einzelne Kreisbereiche auf der Oberfläche des Werkstücks 12, bearbeitet werden. Die lokalen Bereiche können grundsätzlich jegliche Form haben. Sie können kreisförmig, elliptisch, rechteckig, linien- oder punktförmig sein. Insbesondere sind die Teilbereiche zusammenhängend.

In diesem Fall kann für jeden lokalen Bereich ein eigenes Bearbeitungsprofil erstellt werden.

Das Bearbeitungsprofil kann neben dem Verfahrweg 22, der Verweilzeit und dem Anstellwinkel des lonenstrahls 14 weitere den lonenstrahl 14 betreffende Parameter umfassen.

Zum Beispiel kann die Recheneinheit 20 den lonenstrahl 14 derart ansteuern, dass der lonenstrahl 14 während der Bearbeitung pulsiert, um den Energieeintrag zu steuern bzw. den Materialabtrag zu steuern.

Des Weiteren kann die Recheneinheit 20 den lonenstrahl 14 derart ansteuern, dass der Querschnitt des lonenstrahls 14 während eines Bearbeitungsvorgangs verändert wird. Dadurch lässt sich der Durchmesser des auf das Werkstück 12 auftreffenden lonenstrahls 14 variieren. Der lonenstrahl 14 ist also fokussiert, wodurch die gleichzeitig bearbeitete Fläche, also die unter Bestrahlung stehende Fläche, variabel ist.

Der Querschnitt des lonenstrahls 14 kann elliptisch oder kreisrund sein.

Die Intensität des lonenstrahls 14 kann im zeitlichen Mittel während eines Bearbeitungsvorgangs konstant bleiben, insbesondere sofern ein unterschiedlicher Materialabtrag über die Verweilzeit gesteuert wird.

Alternativ kann aber auch die Intensität des lonenstrahls 14 im zeitlichen Mittel während eines Bearbeitungsvorgangs variieren, wodurch beispielsweise längere Verweilzeiten reduziert werden können. Hierdurch kann eine zeitliche Prozessoptimierung erfolgen.

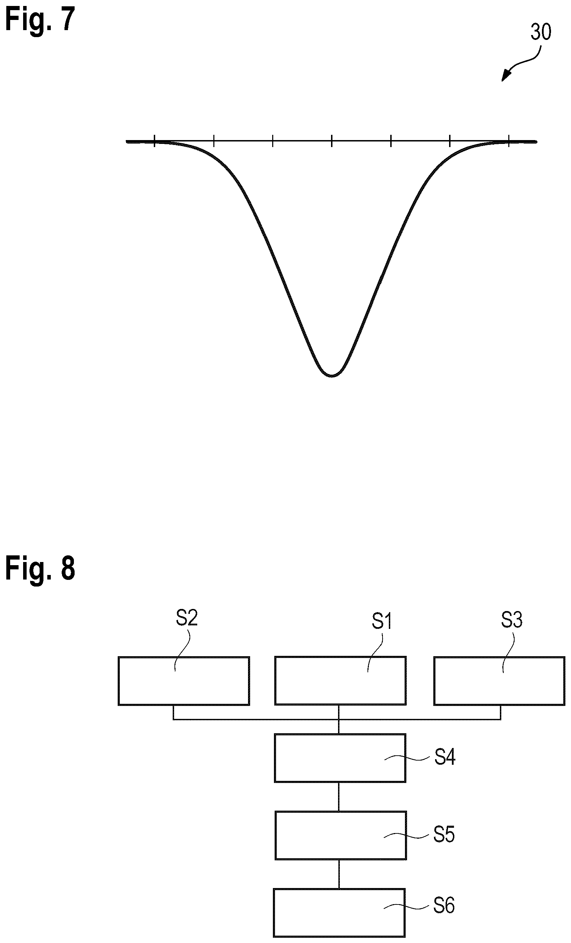

In Figur 7 ist ein Abtragsprofil 30 des lonenstrahls 14 veranschaulicht. Durch das Abtragsprofil 30 ist definiert, in welcher Art der lonenstrahl 14 bei der Bearbeitung Material von der Oberfläche des Werkstücks 12 abträgt.

Das Abtragsprofil 30 des lonenstrahls 14 kann im Rahmen eines Kalibrierungsprozesses vor dem Bearbeiten des Werkstücks 12 erfasst werden. Dieser Vorgang wird üblicherweise in regelmäßigen Zeitabständen wiederholt, da sich das Abtragsprofil 30 im Laufe der Lebensdauer der lonenstrahlquelle 16 ändern kann.

Das Bearbeitungsprofil wird von der Recheneinheit 20 unter Berücksichtigung des Abtragsprofils 30 erstellt.

Anhand von Figur 8 wird ein computerimplementiertes Verfahren zur Ausgabe von Ansteuerungsdaten für das Fünf-Achs-Kinematik-System 18 beschrieben.

In einem Schritt S1 erhält die Recheneinheit 20 die Ist-Werkstückdaten des zu bearbeitenden Werkstücks 12.

In einem Schritt S2 erhält die Recheneinheit 20 die Zieldaten des zu bearbeitenden Werkstücks 12. Beispielsweise wurden die Zieldaten im Vorfeld auf der Recheneinheit 20 hinterlegt oder geladen.

In einem Schritt S3 erhält die Recheneinheit 20 Abtragsprofildaten des lonenstrahls 14. Die Abtragsprofildaten basieren auf dem in Figur 7 veranschaulichten Abtragsprofil.

Die Schritte S1 bis S3 können in beliebiger Reihenfolge oder auch gleichzeitig erfolgen.

In einem Schritt S4, der nach den Schritten S1 bis S3 erfolgt, gleicht die Recheneinheit 20 die Ist-Werkstückdaten des zu bearbeitenden Werkstücks 12 mit den Zieldaten ab.

Anschließend erzeug die Recheneinheit 20 in einem Schritt S5 basierend auf dem Abgleich Bearbeitungsdaten, die zumindest einen Bearbeitungswinkel, den Verfahrweg 22 und eine Verweilzeit des lonenstrahls 14 umfassen. Beim Erzeugen der Bearbeitungsdaten berücksichtigt die Recheneinheit 20 auch die Abtragsprofildaten.

Im Schritt S6 erzeugt die Recheneinheit 20 basierend auf den Bearbeitungsdaten Ansteuerungsdaten zum Ansteuern des Fünf-Achs-Kinematik-Systems 18 der lonenstrahlbearbeitungsanlage 10, wobei die Ansteuerungsdaten derart ausgebildet sind, dass mittels der Ansteuerungsdaten drei Achsen des Fünf-Achs-Kinematik-Systems 18 im Simultanachsverbund angesteuert werden und die zwei weiteren Achsen des Fünf-Achs-Systems 18 lediglich als Zustellachsen dienen.

Die Ansteuerungsdaten können auch Daten zur Ansteuerung der lonenstrahlquelle 16 umfassen, also wie der lonenstrahl 14 während der Bearbeitung erzeugt wird, beispielsweise ein Profil, eine Pulsdauer und/oder ein Energieeintrag.

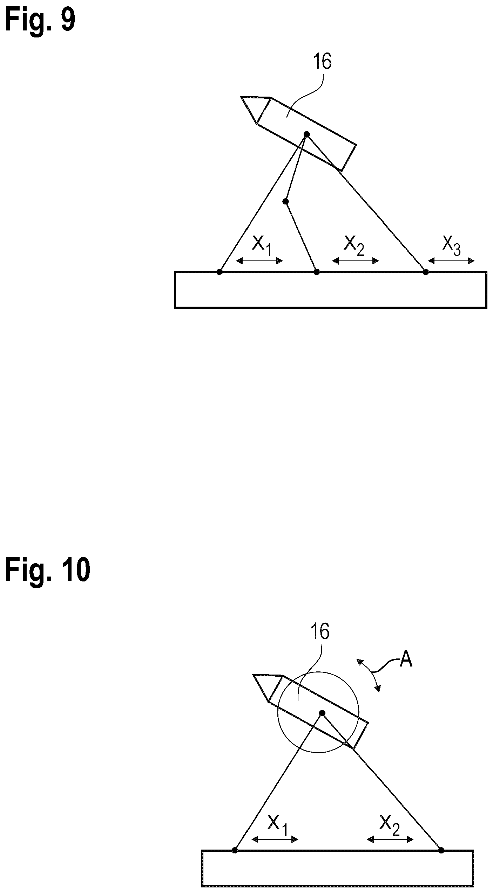

Die Figuren 9 und 10 veranschaulichen ergänzend jeweils eine Parallelkinematik zum Bewegen der lonenstrahlquelle 16, die anstelle eines wie in Zusammenhang mit den vorherigen Figuren beschriebenen Fünf-Achs-Kinematik-Systems 18 mit drei linearen Achsen und zwei Schwenkachsen in der lonenstrahlbearbeitungsanlage 10 vorhanden sein kann.

Bei der in Figur 9 veranschaulichten Kinematik handelt es sich um eine Parallelkinematik mit drei parallelen, linearen Achsen x₁, x₂, x₃. Die Streben der Parallelkinematik können gemeinsam verschoben werden, um die lonenstrahlquelle 16 linear zu verschieben, oder einzeln bzw. paarweise, um die lonenstrahlquelle 16 anzuheben bzw. abzusenken oder zu verschwenken.

Figur 10 zeigt eine Parallelkinematik mit zwei parallelen, linearen Achsen x₁, x₂ und einer Schwenkachse. Durch entsprechendes Verschieben der Streben kann die lonenstrahlquelle 16 linear verschoben und angehoben bzw. abgesenkt werden.

## Patentansprüche

1. Computerimplementiertes Verfahren zur Ausgabe von Ansteuerungsdaten für ein Achssystem einer lonenstrahlbearbeitungsanlage (10) zum Bearbeiten eines Werkstücks (12) mittels eines lonenstrahls (14), wobei gemäß dem computerimplementieren Verfahren folgende Schritte durchgeführt werden:
- eine Recheneinheit (20) erhält Ist-Werkstückdaten eines zu bearbeitenden Werkstückes (12),
- die Recheneinheit (20) erhält Zieldaten des zu bearbeitenden Werkstücks (12),
- die Recheneinheit (20) gleicht die Ist-Werkstückdaten des zu bearbeitenden Werkstücks (12) mit den Zieldaten ab,
- die Recheneinheit (20) erzeugt basierend auf dem Abgleich Bearbeitungsdaten, wobei die Bearbeitungsdaten zumindest einen Bearbeitungswinkel, einen Verfahrweg (22) und eine Verweilzeit eines lonenstrahls (14) umfassen, und
- die Recheneinheit (20) erzeugt basierend auf den Bearbeitungsdaten Ansteuerungsdaten zum Ansteuern eines Fünf-Achs-Kinematik-Systems (18) der lonenstrahlbearbeitungsanlage (10), wobei die Ansteuerungsdaten derart ausgebildet sind, dass mittels der Ansteuerungsdaten drei Achsen des Fünf-Achs-Kinematik-Systems (18) im Simultanachsverbund angesteuert werden und die zwei weiteren Achsen des Fünf-Achs-Systems (18) lediglich als Zustellachsen dienen.

2. Computerimplementiertes Verfahren nach Anspruch 1, **dadurch gekennzeichnet, dass** die Ist-Werkstückdaten mindestens einen der folgenden Parameter umfassen: Werkstückgeometrie, Werkstückmaterial, Abtragsrate des Materials, von dem Werkstückmaterial und/oder der Werkstückgeometrie abhängige Parameter, Schwingverhalten, das Vorhandensein einer Beschichtung, eine Dicke einer Beschichtung, ein Material der Beschichtung und eine Mikrorauigkeit.

3. Computerimplementiertes Verfahren nach einem der vorhergehenden Ansprüche, **dadurch gekennzeichnet, dass** die Zieldaten mindestens einen der folgenden Parameter umfassen: Mikrorauigkeit, Werkstückgeometrie, Schwingverhalten, und Dicke einer Beschichtung.

4. Computerimplementiertes Verfahren einem der vorhergehenden Ansprüche, **dadurch gekennzeichnet, dass** die Recheneinheit (20) Abtragsprofildaten des lonenstrahls (14) erhält, wobei die Abtragsprofildaten berücksichtigt werden, wenn die Bearbeitungsdaten von der Recheneinheit (20) erzeugt werden.

5. Verfahren zum Ansteuern eines Fünf-Achs-Kinematik-Systems (18) einer lonenstrahlbearbeitungsanlage (10) zum Bearbeiten eines nicht-planen Werkstücks (12), insbesondere eines nicht-sphärischen bzw. parabolischen Werkstücks (12), wobei die Bearbeitung insbesondere im Vakuum stattfindet, wobei die lonenstrahlbearbeitungsanlage (10) ein Fünf-Achs-Kinematik-System (18) und mindestens eine durch das Fünf-Achs-Kinematik-System (18) bewegbare lonenstrahlquelle (16) sowie eine Recheneinheit (20) zum Ansteuern des Fünf-Achs-Kinematik-Systems (18) umfasst, wobei das Verfahren die folgenden Schritte umfasst:
- die Recheneinheit (20) erhält Ist-Werkstückdaten eines zu bearbeitenden Werkstücks (12),
- die Ist-Werkstückdaten des Werkstücks (12) werden mit Zieldaten des Werkstücks (12) verglichen und basierend auf einer Abweichung der Ist-Werkstückdaten von den Zieldaten wird ein Bearbeitungsprofil durch die Recheneinheit (20) erstellt, wobei das Bearbeitungsprofil einen Verfahrweg (22), eine Verweilzeit und einen Anstellwinkel der lonenstrahlquelle relativ zu der Oberfläche des Werkstücks (12) umfasst, und
- wobei die Recheneinheit (20) entsprechend des Bearbeitungsprofils drei Achsen des Fünf-Achs-Kinematik-Systems (18) simultan ansteuert, um die lonenstrahlquelle (16) mit einer dem Bearbeitungsprofil entsprechenden Verweilzeit und einem dem Bearbeitungsprofil entsprechenden Anstellwinkel entlang des Verfahrwegs (22) zu verfahren, und die Recheneinheit (20) die übrigen beiden Achsen des Fünf-Achs-Kinematik-Systems (18) lediglich zum Zustellen der lonenstrahlquelle (16) an den Verfahrweg (22) ansteuert.

6. Verfahren nach Anspruch 5, **dadurch gekennzeichnet, dass** das Werkstück (12) analysiert wird, um Ist-Werkstückdaten des Werkstücks (12) zu erfassen.

7. Verfahren nach Anspruch 5 oder 6, **dadurch gekennzeichnet, dass** die Recheneinheit (20) zwei zueinander orthogonale lineare Achsen und eine Schwenkachse simultan ansteuert.

8. Verfahren nach einem der Ansprüche 5 bis 7, **dadurch gekennzeichnet, dass** für unterschiedliche auf dem Werkstück (12) liegende lokale Bereiche jeweils ein eigenes Bearbeitungsprofil erstellt wird.

9. Verfahren nach einem der Ansprüche 5 bis 8, **dadurch gekennzeichnet, dass** vor dem Bearbeiten des Werkstücks (12) ein Abtragsprofil (30) des lonenstrahls (14) erfasst wird und das Bearbeitungsprofil unter Berücksichtigung des Abtragsprofils (30) erstellt wird.

10. Verfahren nach einem der Ansprüche 5 bis 9, **dadurch gekennzeichnet, dass** der Anstellwinkel des lonenstrahls (14) relativ zur Oberfläche des Werkstücks (12) während eines Bearbeitungsvorgangs konstant bleibt.

11. Verfahren nach einem der Ansprüche 5 bis 10, **dadurch gekennzeichnet, dass** die Recheneinheit (20) eingerichtet ist, die lonenstrahlquelle (16) derart anzusteuern, dass der lonenstrahl (14) während der Bearbeitung pulsiert.

12. Verfahren nach einem der Ansprüche 5 bis 11, **dadurch gekennzeichnet, dass** die Intensität des lonenstrahls (14) während eines Bearbeitungsvorgangs konstant bleibt.

13. Verfahren nach einem der Ansprüche 5 bis 12, **dadurch gekennzeichnet, dass** die lonenstrahlquelle (16) fokussiert ist, insbesondere wobei der Querschnitt des lonenstrahls (14) während eines Bearbeitungsvorgangs verändert wird.

14. Verfahren nach einem der Ansprüche 5 bis 13, **dadurch gekennzeichnet, dass** der Verfahrweg (22) mäanderförmig ist.

15. Werkstück (12) mit einer nicht-sphärischen Oberfläche, das mittels eines Verfahrens gemäß einem der Ansprüche 5 bis 14 bearbeitet wurde, wobei das Werkstück (12) über die bearbeitete Oberfläche hinweg eine einheitliche Mikrorauigkeit aufweist.

16. lonenstrahlbearbeitungsanlage (10) zum Bearbeiten eines Werkstücks (12) mittels eines lonenstrahls (14), wobei die lonenstrahlbearbeitungsanlage (10) ein Fünf-Achs-Kinematik-System (18) und mindestens eine durch das Fünf-Achs-Kinematik-System (18) bewegbare lonenstrahlquelle (16) sowie eine Recheneinheit (20) zum Ansteuern des Fünf-Achs-Kinematik-Systems (18) umfasst, und wobei die Recheneinheit (20) eingerichtet ist, das Verfahren gemäß einem der Ansprüche 1 bis 4 auszuführen, um das Fünf-Achs-Kinematik-System (18) mittels der erzeugten Ansteuerungsdaten anzusteuern.
